# EUROPEAN PATENT APPLICATION

(11) **EP 1 351 393 A1**
(43) Date of publication of application: **08.10.2003**
(21) Application number: 03075892.4
(22) Date of filing: 27.03.2003
(51) Int. Cl.: H03K 19/0948, G06F 7/50

(54) **Device and method for adding and/or subtracting**

(30) Priority: 02.04.2002 NL 1020289
(71) Applicant: Van De Pol, Jan Hendrik, 7548 PN Enschede (NL)
(72) Inventor: Van De Pol, Jan Hendrik, 7548 PN Enschede (NL)
(74) Representative: Land, Addick Adrianus Gosling

(57) **Abstract**

The present invention relates to a logic circuit, comprising a first and a second MOS transistor wherein the two transistors are coupled to each other with the control electrodes and the drain electrodes.

In a preferred embodiment the invention provides a logic circuit according to claim 1, wherein the first MOS transistor is a PMOS transistor and the second MOS transistor is an NMOS transistor.

A further aspect of this invention relates to a Full Adder comprising such circuits. One advantage of these circuits is that a very small number of elements is required.

## Description

The present invention relates to a logic circuit, comprising a first and a second MOS transistor wherein the two transistors are coupled to each other with the control electrodes and the drain electrodes.

The logic circuit preferably has the feature that the first MOS transistor is a PMOS transistor and the second MOS transistor is an NMOS transistor. Such circuits have the advantage that logic gates can be embodied in simple manner with few electronic components, in this case transistors.

A second logic circuit, wherein the first MOS transistor is an NMOS transistor and the second MOS transistor is a PMOS transistor, also has such an advantage.

Further preferred embodiments provide respectively:
- a logical AND circuit (1), wherein a voltage representing a logical zero is fed to the source of the PMOS transistor, a voltage representing a first term is fed to the control electrodes and a voltage representing a second term is fed to the source of the NMOS transistor, wherein this circuit complies with a truth table of 1H.
- a logic CNIM circuit (4), wherein a voltage representing a logical zero is fed to the source of the NMOS transistor, a voltage representing a first term is fed to the control electrodes and a voltage representing a second term is fed to the source of the PMOS transistor, wherein this circuit complies with a truth table of 4H.
- a logical OR circuit (7), wherein a voltage representing a logical one is fed to the source of the NMOS transistor, a voltage representing a first term is fed to the control electrodes and a voltage representing a second term is fed to the source of the PMOS transistor, wherein this circuit complies with a truth table of 7H.
- a logic IMP circuit (13), wherein a voltage representing a logical one is fed to the source of the PMOS transistor, a voltage representing a first term is fed to the control electrodes and a voltage representing a second term is fed to the source of the NMOS transistor, wherein this circuit complies with a truth table of DH.

A preferred embodiment relates to an adder, comprising:
- a first circuit which has the carry of the adder as output,
- a second circuit which has the sum of the adder as output,
- an AND circuit which is connected to the first circuit, a CLAIM circuit and an IMP circuit,
- an OR circuit which is connected to the first circuit, the CNIM circuit and the IMP circuit,
- a CNIM circuit, the output of which is connected to the second circuit,
- an IMP circuit, the output of which is connected to the second circuit.

The advantages of such an adder are that it is dual and that very few transistors are used. This application enables a very advantageous operation, since few operating steps are necessary to perform an addition. A further advantage of a small number of components is that the device can be manufactured more cheaply. Further advantages hereof are that such circuits take up little space and/or produce little heat since few transistors are required.

A further embodiment with such advantages is a subtractor, comprising:
- a first circuit which has the borrow of the subtractor as output,
- a second circuit which has the difference of the subtractor as output,
- a first CNIM circuit which is connected to the first circuit, a second CNIM circuit and a second IMP circuit,
- a first IMP circuit which is connected to the first circuit, a second CLAIM circuit and a second IMP circuit,
- a second CLAIM circuit which is connected to the second first circuit,
- a second IMP circuit which is connected to the second first circuit.

Further advantages, features and details of the present invention will be further explained with reference to the annexed figures, in which:
- figure 1 is a schematic representation of embodiments according to the present invention;
- figure 2 is a schematic representation of an embodiment according to the present invention;
- figure 3 is a schematic representation of a further embodiment according to the present invention;
- figure 4 is a schematic representation of embodiments according to the present invention;
- figures 5, 6 are schematic representations of further embodiments according to the present invention;
- figure 7 is a schematic representation of a further embodiment according to the present invention.

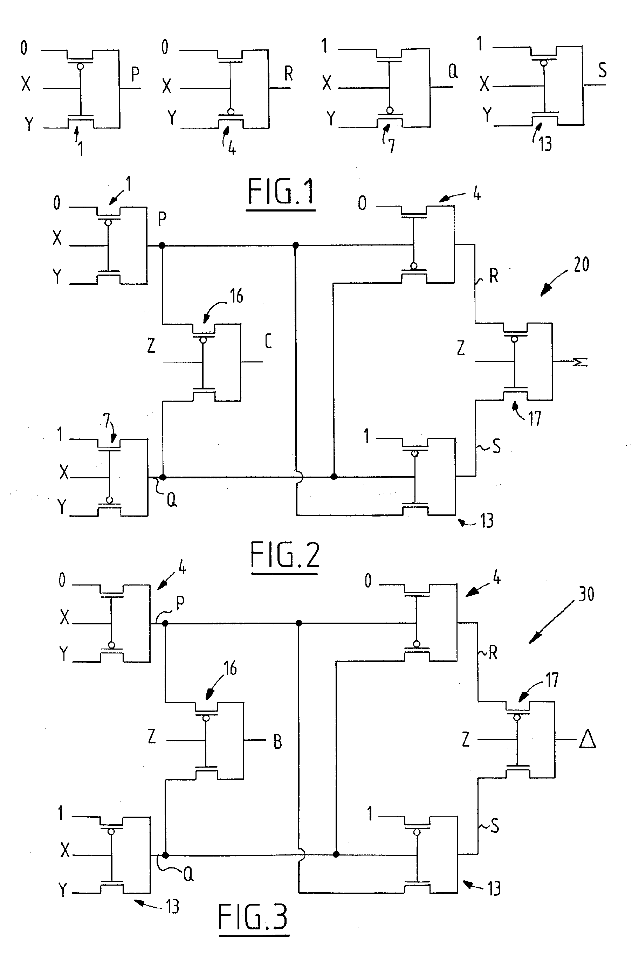

Embodiments wherein a PMOS and an NMOS transistor together form a gate wherein the control electrodes are mutually connected (Fig. 1) can be used as components for two embodiments (Fig. 2, 3) of the present invention, which are a Dual Full Adder (Fig. 2) and a Dual Full Subtractor (Fig. 3). An NMOS transistor is designated here by a MOS transistor without circle at the control electrodes and a PMOS is designated by a MOS transistor with a circle at the control electrodes.

Fig. 1 shows four embodiments which form four gates. These gates each have a truth table, the value of whose output p,r,q,s depends on the values of the input x,y:

| | | | | | |
|---|---|---|---|---|---|
| NAME | X=0 | X=0 | X=0 | X=1 | Hexadecimal |
| GATE | Y=0 | Y=1 | Y=0 | Y=1 | symbol |
| AND | 0 | 0 | 0 | 1 | 1 H (1) |
| CNIM | 0 | 1 | 0 | 0 | 4 H (4) |
| OR | 0 | 1 | 1 | 1 | 7 H (7) |
| IMP | 1 | 1 | 0 | 1 | D H (13) |

Truth table 1.

The gate with 1 H as hexadecimal value, the AND gate, consists of a PMOS and an NMOS transistor. These transistors are connected to each other with the control electrodes. These control electrodes also receive one of the two inputs (input values) X for processing. A second input Y for processing enters at the source of the NMOS transistor. An auxiliary signal 0 is fed to the sources of the PMOS, which is necessary to have this transistor configuration function as AND gate. The output value p of this gate will comply with the truth table for the AND gate.

The CNIM, OR and IMP gates shown in figure 1 comply in similar manner with the truth table 1 shown above. For the sake of clarity the reference numerals of the gates correspond with the hexadecimal values of their truth table. This numbering is also applied in figures 2 and 3.

A further embodiment (fig. 2) is a dual adder. In this adder, four of the above stated gates 1, 4, 7, 13 are applied, and two auxiliary gates 16, 17 are further applied which have the physical structure of a gate with the truth table 1H or DH.

Depending on the output values of the other gates, these auxiliary gates will behave as an AND gate or an IMP gate. The output value of gate 16 forms the carry of the Dual Full Adder 20. The output value of gate 17 forms the adding result S of Full Adder 20. The input of gates 16 and 17 is formed by the old carry of a possible previous Full Adder operation. The Dual Full Adder calculates the sum of the input values X and Y and can herein also calculate the carry C. The adder is hereby a Full Adder.

In adder 20 the output of AND gate 1 is fed to the X-input of CNIM gate 4, to the source of the PMOS transistor of auxiliary gate 16 and to the Y-input of IMP gate 13. The output q of OR gate 7 is fed to the control electrodes of IMP gate 13 and the Y-input of CNIM gate 4 and to the source of the NMOS transistor of auxiliary gate 16.

The output r of CLAIM gate 4 is fed in similar manner to the source of the PMOS transistor of auxiliary gate 17. The output s of IMP gate 13 is also fed to the source of the NMOS transistor of auxiliary gate 17.

The truth table 2 for adder 20 as a whole is as follows:

| | | | | |
|---|---|---|---|---|
| X Y Z | p q | C | r s | S |
| 0 0 0 | 0 0 | 0 | 0 1 | 0 |
| 0 1 0 | 0 1 | 0 | 1 0 | 1 |
| 1 0 0 | 0 0 | 0 | 1 0 | 1 |
| 1 1 0 | 0 1 | 1 | 0 1 | 0 |
| 0 0 1 | 0 0 | 0 | 0 1 | 1 |
| 0 1 1 | 0 1 | 1 | 1 0 | 0 |
| 1 0 1 | 0 1 | 1 | 1 0 | 0 |
| 1 1 1 | 1 1 | 1 | 0 1 | 1 |

Truth table 2.

Figure 3 shows a subtractor 30. The subtractor likewise comprises six gates, of which two CLAIM gates 4, two IMP gates 13 and two auxiliary gates have the same transistor arrangement as the AND and the IMP gates, wherein the truth table of these auxiliary gates depends on the value of p and r in similar manner as in the adder of figure 2.

The output value of gate 16 forms the borrow of the Dual Full Subtractor 30. The output value of gate 17 forms the subtraction result Δ of Full Subtractor 30. The input of gates 16 and 17 is formed by the old borrow of a possible full subtracting operation.

The Dual Full subtractor calculates the difference between input values X and Y and can herein also calculate the borrow B. The subtractor is hereby a Full Subtractor.

In the first CLAIM gate 4 a zero value is fed to the NMOS transistor, the X value is fed to the control electrodes of the NMOS and the PMOS and the Y value is fed to the source of the PMOS transistor. The logical result p of the CNIM gate is fed to the X value of the second CNIM gate 4 as well as to the Y value of second IMP gate 13 and to the source of the PMOS transistor of auxiliary gate 16.

The X-value is also fed to the control electrodes of the PMOS and the NMOS of the first IMP gate 13. The Y value is fed to the source of the NMOS of IMP gate 13 and the value 1 is fed to the source of the PMOS of IMP gate 13. The output value q of IMP gate 13 is fed to the source of the NMOS transistor of auxiliary gate 16 as well as to the source of the PMOS transistor of the second CNIM gate 4 and the control electrode of both the PMOS transistor and the NMOS transistor of the second IMP gate 13.

The results r, s of the second CNIM gate 4 and of the second IMP gate 13 are fed respectively to the source of the PMOS transistor and the NMOS transistor of auxiliary gate 17.

The old borrow Z is further fed to the control electrodes of the PMOS and the NMOS transistor of auxiliary gate 17. On the basis of this input the auxiliary gate 17 produces the subtraction result Δ of subtractor 30.

The truth table for the subtractor 30 as a whole is as follows:

| | | | | |
|---|---|---|---|---|
| X Y Z | p q | B | r s | Δ |
| 0 0 0 | 0 1 | 0 | 1 0 | 1 |
| 0 1 0 | 1 1 | 1 | 0 1 | 0 |
| 1 0 0 | 0 0 | 0 | 0 1 | 0 |
| 1 1 0 | 0 1 | 0 | 1 0 | 1 |
| 0 0 1 | 0 1 | 1 | 1 0 | 0 |
| 0 1 1 | 1 1 | 1 | 0 1 | 1 |
| 1 0 1 | 0 0 | 0 | 0 1 | 1 |
| 1 1 1 | 0 1 | 1 | 1 0 | 0 |

Truth table 3.

Particular advantages of these embodiments are that on the one hand the gates are embodied making use of only two transistors and on the other a Dual Full Adder and a Dual Full Subtractor can be made using only twelve transistors, as a result of the above described arrangements.

A further advantage of the embodiments as specified above is that the adder and the subtractor are dual.

A further advantage of this duality is that it becomes possible to apply a clock having both positive and negative voltage values, since owing to the duality the same adding and subtracting results will be obtained irrespective of the sign of the voltage.

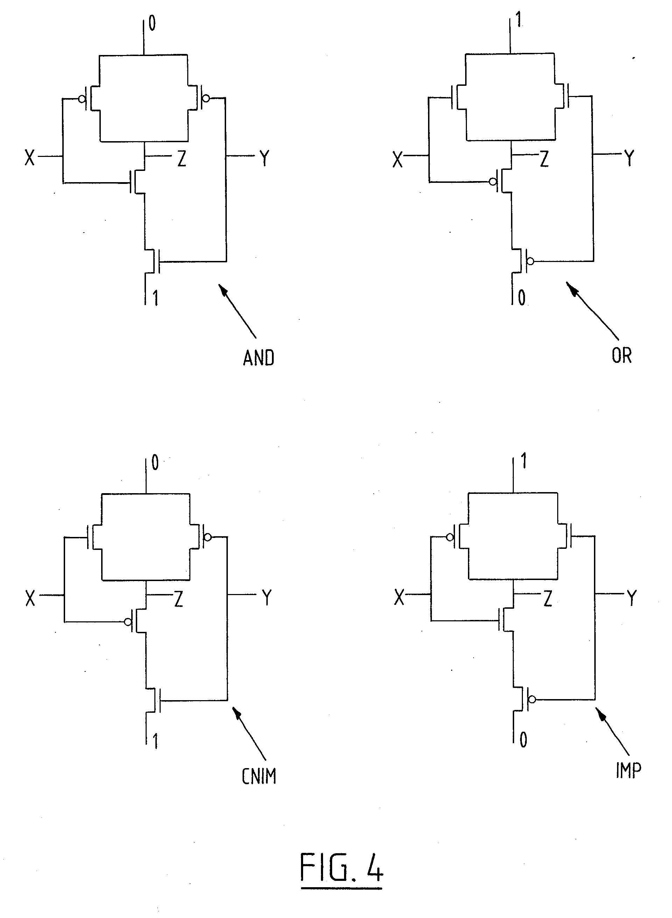

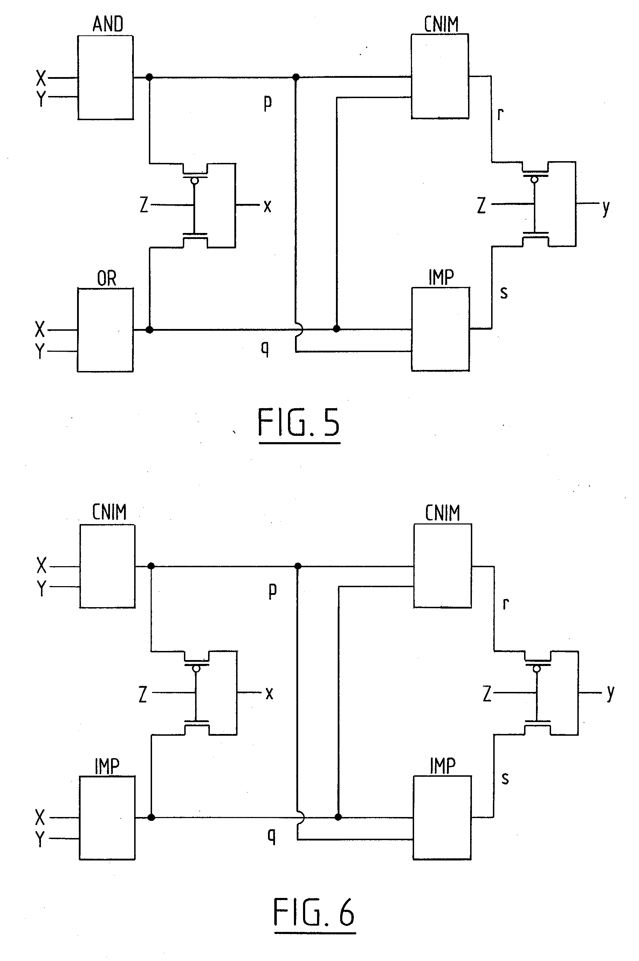

Other embodiments of the gates of figure 1 (fig. 4) comprise four transistors. An adder according to the present invention can also be assembled making use of gates according to figure 4. Figure 5 shows an adder which is similar to the adder of figure 1 in respect of results, wherein however the gates are applied as shown in figure 4. In similar manner a subtractor is shown in figure 6 with an operation analogous to that of the subtractor of figure 3, wherein the gates are applied as according to figure 4. This adder and subtractor of figures 5 and 6 have advantages similar to those of figures 2 and 3.

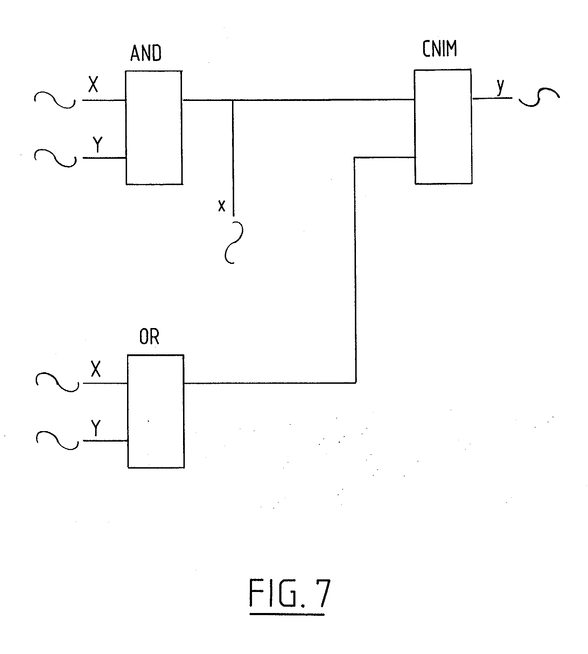

In a further embodiment (fig. 7) a dual adder is shown which comprises only three gates according to figure 1 or figure 4. It is therefore possible using this embodiment to manufacture a dual adder consisting of three gates, or only six transistors, while making use of the gates of figure 1. A condition for the operation of this embodiment is that, instead of using the direct current much applied in a digital environment as input and output, use is made here of alternating current as input and output. During the negative phase the polarity of the input and output signals X, Y, x, y is reversed so that the second half of the truth table is applied.

The logical operation of a Dual Full Adder can also be explained on the basis of computer programs which are programmed such that the logical operation of above described preferred embodiments is simulated. The program code below is shown in the syntax of microProlog. The following two programs each describe a multi-bit adder. First described are Dual Full Adders, formulated in different ways. Following this a four-bit iterative adder in the first program and a multi-bit recursive adder in the second.

The third program describes a Dual Full Adder which depends the polarity of the input and output being reversed (Fig. 7), which can in principle be brought about with alternating current.

The listing of the iterative Dual Full Adder is as follows:
% dual full adder
% n- and p-transistors
ntrans(1,Io,Io).
ntrans(0,In,Out).
ptrans(0,Io,Io).
ptrans(1,In,Out).
% and, or, cnim and imp gates and(In1,In2,Out):-ntrans(In1,In2,Out),ptrans(In1,0,Out). or (In1,In2,Out):-ntrans(In1,1,Out),ptrans(In1,In2,Out). cnim(In1,In2,Out):-ntrans(Inl,0,Out),ptrans(In1,In2,Out). imp(In1,In2,Out):-ntrans(In1,In2,Out),ptrans(In1,1,Out). % half adder
halfadder(In1,In2,Carry,Sum) :-
and(In1,In2,Carry),or(In1,In2,Interm),
cnim(Carry,Interm,Sum).
% dual or half adder
halfaddual(In1,In2,Carry,Sum):-
or(In1,In2,Carry),and(In1,In2,Interm),
imp(Carry,Interm,Sum).
% dual full adder; Query: fulladder(I1,I2,O,C,S) fulladder(In1,In2,0,Carry,Sum):-
halfadder(In1,In2,Carry,Sum).
fulladder(In1,In2,1,Carry,Sum):-
halfaddual(In1,In2,Carry,Sum).
% Iterative adder
% Query: adder(In1-4,In2-4,Sum-5)
adder([14,I3,I2,I1],[J4,J3,J2,J1],[S5,S4,S3,S2,S1]):-
fulladder(I1,J1,0,R2,S1),
fulladder(I2,J2,R2,R3,S2),
fulladder(I3,J3,R3,R4,S3),
fulladder(I4,J4,R4,S5,S4).

The listing of the recursive Dual Full Adder in microProlog is as follows:
% dual full adder
% n- and p-transistors
ntrans(1,Io,Io).
ntrans(0,In,Out).
ptrans(0,Io,Io).
ptrans(1,In,Out).
% and, or, cnim and imp gates
and(In1,In2,Out):-ntrans(In1,In2,Out),ptrans(In1,0,Out). or(In1,In2,Out):-ntrans(In1,1,Out),ptrans(In1,In2,Out). cnim(In1,In2,Out):-ntrans(In1,0,Out),ptrans(In1,In2,Out). imp(In1,In2,Out):-ntrans(In1,In2,Out),ptrans(In1,1,Out). % dual full adder; Query: dualadder(I1,I2,O,C,S) dualadder(In1,In2,Oldcarry,Carry,Sum):-
   and (In1,In2,Temp1),
   or (In1,In2,Temp2),
   ptrans(Oldcarry,Templ,Carry),ntrans(Oldcarry,Temp2, Carry),
   cnim(Temp1,Temp2,Temp3),
   imp(Temp2,Temp1,Temp4),
   ptrans(Oldcarry,Temp3,Sum),ntrans(Oldcarry,Temp4,Sum).
% Recursive adder
% Query: adder([X|Xs], [Y|Ys],Old, [Z|Zs],New,Pulse) adder([], [],X, [],0,X).
adder([X|Xs],[Y|Ys],Old,[Z|Zs],New,Pulse) :-
   eq(New,Pulse),
   adder(Xs,Ys,New,Zs,Temp,Pulse),
   dualadder(X,Y,Temp,New,Z). adder([X|Xs],[Y|Ys],Old,[Z|Zs],New,Pulse):-
   pol(New,Pulse),
   adder(Xs,Ys,New,Zs,Temp,Pulse),
   dualadder(X,Y,Temp,New,Z).
   % equality
   eq(X,X).
   % pole reversal
   pol(1,0).
   pol(0,1).

A listing of a Dual Full Adder which makes use of polarity reversal and alternating current is as follows:
% n- and p-transistors
ntrans(1,Io,Io).
ntrans(0,In,Out).
ptrans(0,Io,Io).
ptrans(1,In,Out).
% and, or, cnim and imp gates
and(In1,In2,Out):-ntrans(In1,In2,Out),ptrans(In1,0,Out). or(In1,In2,Out):-ntrans(In1,1,Out),ptrans(In1,In2,Out). cnim(In1,In2,Out):-ntrans(In1,0,Out),ptrans(In1,In2,Out). imp(In1,In2,Out):-ntrans(In1,In2,Out),ptrans(In1,1,Out). % halfadder
halfadder(In1,In2,Carry,Sum) :-
   and(In1,In2,Carry),or(In1,In2,Interm),
   cnim(Carry,Interm,Sum).
% dual full adder
fulladder(In1,In2,0,Carry,Sum):-
   halfadder(In1,In2,Carry,Sum).
fulladder(In1,In2,1,Carry,Sum):-
   pol(In1,T1),pol(In2,T2),
   halfadder(T1,T2,Carry,Sum),
   pol(T3,Carry),pol(T4,Sum).
% pole reversal
   pol(1,0).
   pol(0,1).

The present invention is not limited to the described preferred embodiments; the rights sought are defined by the following claims.

## Claims

1. Logic circuit, comprising a first and a second MOS transistor wherein the two transistors are coupled to each other with the control electrodes and the drain electrodes.

2. Logic circuit as claimed in claim 1, wherein the first MOS transistor is a PMOS transistor and the second MOS transistor is an NMOS transistor.

3. Logic circuit as claimed in claim 1, wherein the first MOS transistor is an NMOS transistor and the second MOS transistor is a PMOS transistor.

4. Logical AND circuit (1) as claimed in claim 2, wherein a voltage representing a logical zero is fed to the source of the PMOS transistor, a voltage representing a first term is fed to the control electrodes and a voltage representing a second term is fed to the source of the NMOS transistor, wherein this circuit complies with a truth table of 1H (see table 1).

5. Logic CNIM circuit (4) as claimed in claim 3, wherein a voltage representing a logical zero is fed to the source of the NMOS transistor, a voltage representing a first term is fed to the control electrodes and a voltage representing a second term is fed to the source of the PMOS transistor, wherein this circuit complies with a truth table of 4H (see table 1).

6. Logical OR circuit (7) as claimed in claim 3, wherein a voltage representing a logical one is fed to the source of the NMOS transistor, a voltage representing a first term is fed to the control electrodes and a voltage representing a second term is fed to the source of the PMOS transistor, wherein this circuit complies with a truth table of 7H (see table 1).

7. Logic IMP circuit (13) as claimed in claim 2, wherein a voltage representing a logical one is fed to the source of the PMOS transistor, a voltage representing a first term is fed to the control electrodes and a voltage representing a second term is fed to the source of the NMOS transistor, wherein this circuit complies with a truth table of DH (see table 1).

8. Adder, comprising:
- a first circuit as claimed in claim 2 which has the carry of the adder as output,
- a second circuit which has the sum of the adder as output,
- an AND circuit as claimed in claim 4 which is connected to the first circuit, a CNIM circuit and an IMP circuit,
- an OR circuit as claimed in claim 6 which is connected to the first circuit, the CNIM circuit and the IMP circuit,
- a CNIM circuit as claimed in claim 5, the output of which is connected to the second circuit,
- an IMP circuit as claimed in claim 7, the output of which is connected to the second circuit.

9. Subtractor, comprising:
- a first circuit as claimed in claim 2 which has the borrow of the subtractor as output,
- a second circuit which has the difference of the subtractor as output,
- a first CNIM circuit as claimed in claim 5 which is connected to the first circuit, a second CNIM circuit and a second IMP circuit,
- a first IMP circuit as claimed in claim 7 which is connected to the first circuit, a second CNIM circuit and a second IMP circuit,
- a second CNIM circuit which is connected to the second first circuit,
- a second IMP circuit which is connected to the second first circuit.

10. Adder, comprising:
- a first circuit as claimed in claim 2 which has the carry of the adder as output,
- a second circuit which has the sum of the adder as output,
- an AND circuit which is connected to the first circuit, a CNIM circuit and an IMP circuit,
- an OR circuit which is connected to the first circuit, the CNIM circuit and the IMP circuit,
- a CNIM circuit which is connected to the second circuit,
- an IMP circuit which is connected to the second circuit.

11. Subtractor, comprising:
- a first circuit as claimed in claim 2 which has the borrow of the subtractor as output,
- a second circuit which has the difference of the subtractor as output,
- a first CNIM circuit which is connected to the first circuit, a second CNIM circuit and a second IMP circuit,
- a first IMP circuit which is connected to the first circuit, a second CLAIM circuit and a second IMP circuit,
- a second CLAIM circuit which is connected to the second first circuit,
- a first IMP circuit which is connected to the second first circuit.

12. Adder for operating with alternating current input signals, comprising:
- an AND circuit as claimed in claim 4 which is connected to a CNIM circuit and which has the carry of the adder as output,
- an OR circuit as claimed in claim 6 which is connected to a CNIM circuit as claimed in claim 5,
- a CNIM circuit as claimed in claim 5 which has the output of the AND circuit and the output of the OR circuit as input and the sum of the adder as output.
